# FASCICULE DE BREVET EUROPEEN

(11) **EP 3 997 765 B1**
(45) Date de publication et mention de la délivrance du brevet: **11.11.2026**
(21) Numéro de dépôt: 20737192.3
(22) Date de dépôt: 08.07.2020
(51) Int. Cl.: H01R 13/66, H01R 13/641, H01R 13/71, H01R 43/26, F21S 41/19, H01R 12/70

(54) **ENSEMBLE DE CONNEXION ELECTRIQUE POUR MODULE LUMINEUX DE VEHICULE AUTOMOBILE ET PROCEDE**
ELEKTRISCHE VERBINDUNGSANORDNUNG FÜR EIN LICHTMODUL FÜR EIN KRAFTFAHRZEUG UND VERFAHREN
ELECTRICAL CONNECTION ASSEMBLY FOR LIGHT MODULE FOR MOTOR VEHICLE AND METHOD

(30) Priorité: 09.07.2019 FR 1907687; 09.07.2019 FR 1907689; 09.07.2019 FR 1907691
(43) Date de publication de la demande: 18.05.2022
(73) Titulaire: Valeo Vision, 93012 Bobigny Cedex (FR)
(72) Inventeur: MONCHY, Etienne, 93012 BOBIGNY CEDEX (FR); FERNANDEZ, Berta, 93012 BOBIGNY CEDEX (FR); JOSEPHINE, Juliette, 93012 BOBIGNY CEDEX (FR)
(74) Mandataire: Valeo Visibility
(86) Numéro de dépôt international: PCT/EP2020/069312
(87) Numéro de publication internationale: WO 2021/005134

(56) Documents cités:
- FR-A1- 3 056 702
- FR-A1- 3 056 702
- US-A- 4 915 648
- US-A- 4 915 648
- US-A- 5 144 189
- US-A- 5 144 189

## Description

L'invention se rapporte aux connecteurs électriques, notamment entre composants électroniques d'un module lumineux pour un véhicule automobile. En particulier, l'invention se rapporte à l'utilisation de connecteurs de type CPA (« connection position assurance »), ayant un dispositif de d'assurance de position.

Un module lumineux pour un véhicule automobile est un dispositif complexe impliquant une pluralité de technologies dans un espace très restreint. Celui-ci comprend entre autres des composants optiques, des composants lumineux tels que des diodes électroluminescentes, LED, des circuits électroniques de pilotage de sources lumineuses, des supports mécaniques, des éléments de dissipation d'humidité et de chaleur. L'assemblage d'un tel module est une tâche complexe qui requiert un degré d'attention et de précision élevée. Ceci est particulièrement le cas pour l'interconnexion électrique de différents composants électriques et/ou circuits imprimés impliqués dans un tel module lumineux. A titre d'exemple, un circuit de pilotage de l'alimentation électrique de sources lumineuses doit être connecté par le biais d'un connecteur à un circuit imprimé qui abrite les sources lumineuses à alimenter en électricité. Un opérateur doit souvent faire ces connexions sans avoir un contact visuel direct du connecteur et de la prise correspondante - l'opération doit se faire à l'aveugle du fait que d'autres composants sont déjà assemblés dans le volume restreint disponible du module. La connexion d'un harnais entre deux circuits imprimés doit résister à des contraintes externes. Par exemple, elle doit résister de manière fiable aux vibrations auxquelles le module lumineux sera soumis lors de la conduite du véhicule automobile dont il fait partie de l'équipement. Il est donc important de pouvoir s'assurer d'une connexion adéquate au moment de l'assemblage.

FR 3 056 702 A1 divulgue un ensemble de connexion électrique selon le préambule de la revendication 1.

Il est connu d'utiliser des connecteurs électriques ayant un dispositif d'assurance de position, de type CPA (« connection position assurance »). De tels connecteurs présentent typiquement une pluralité de contacts ayant une première longueur et un contact de vérification plus court, qui n'entre en contact électrique fiable avec un terminal correspondant d'une prise que si un enfoncement d'une certaine profondeur de la fiche dans la prise est réalisé. Une prise de connecteur CPA connue comprend également un châssis ayant des ergots latéraux qui coopèrent avec une structure de réception correspondante aux ergots au niveau de la fiche. L'encliquetage d'un premier ergot distal assure que les connecteurs de la première longueur sont en contact électrique avec les terminaux correspondants de la prise. L'encliquetage d'un deuxième ergot proximal assure que tous les connecteurs sont en contact électrique avec les terminaux correspondants de la prise.

Afin de minimiser le risque d'erreurs ou de mauvaise connexion lors de l'assemblage d'un module lumineux pour un véhicule automobile, il peut être intéressant d'utiliser un signal électrique sur le contact de vérification afin de tester le degré d'enfoncement de la fiche dans la prise. De manière générale, un surplus de composant électroniques au niveau du module lumineux est pourtant à éviter puisque le surcoût de production augmente avec chaque composant et est amplifiée lors de la production en masse d'un tel module.

L'invention a pour objectif de pallier au moins un des problèmes posés par l'art antérieur. Plus précisément, l'invention a pour objectif de proposer un ensemble de connexion électrique qui permet de vérifier la tenue d'un connecteur dans une prise moyennant un signal électrique de vérification, et utilisant un minimum de composants électroniques.

Selon l'invention tel que definie dans la revendication 1, un ensemble de connexion électrique est proposé. L'ensemble comprend un connecteur et un circuit imprimé qui comprend une prise correspondant au connecteur et un premier sous-circuit électronique participant à la réalisation d'une fonction lumineuse d'un véhicule automobile. Le connecteur comprend un contact de vérification destiné à la transmission d'un signal électrique de vérification de la connexion électrique entre le connecteur et le circuit imprimé, dans lequel le circuit imprimé comprend un deuxième sous-circuit ayant un terminal de contact destiné à être relié audit contact de vérification en cas de tenue du connecteur dans la prise.

De préférence, le deuxième sous-circuit ne participe pas de manière active dans la réalisation de ladite fonction lumineuse.

De préférence, le connecteur et la prise peuvent comprendre une structure d'enclenchement mécanique mutuel, qui permet la réalisation d'un premier enclenchement mécanique correspondant à un premier degré moindre, et d'un deuxième enclenchement mécanique correspondant à un deuxième degré plus important d'enfoncement du connecteur dans la prise. L'agencement du contact de vérification et du terminal de contact du deuxième sous-circuit peut de préférence être tel qu'ils sont en contact électrique si le deuxième enclenchement mécanique de la structure est engagé.

La prise peut préférentiellement comprendre une pluralité de contacts s'étendant sur une première longueur, le terminal de contact peut s'étendre sur une deuxième longueur plus courte.

Le deuxième sous-circuit peut de préférence être agencé de manière être relié au potentiel de masse, lorsque le connecteur est enfiché dans la prise.

De préférence, le deuxième sous-circuit est agencé pour relier le terminal de contact au potentiel de masse à travers une branche comprenant un composant résistif.

Le deuxième sous-circuit peut de préférence être agencé de manière à relier le terminal de contact au potentiel de masse à travers au moins une branche qui comprend une capacité, une inductance, une résistance, ou une combinaison de ce qui précède.

De manière préférée, le connecteur peut comprend un premier contact destiné à fournir un premier potentiel électrique non-nul au premier sous-circuit, et un deuxième contact destiné à fournir un deuxième potentiel électrique non-nul au premier sous-circuit. L'agencement peut de préférence être tel que e contact de vérification soit relié au premier potentiel électrique lorsque le connecteur est enfiché dans la prise.

Le deuxième sous-circuit peut de préférence être agencé de manière à être relié au deuxième potentiel électrique lorsque le connecteur est enfiché dans la prise.

De préférence, deuxième sous-circuit peut comprendre un composant résistif.

Le deuxième sous-circuit peut de préférence comprendre un fusible.

De préférence, le deuxième sous-circuit peut comprendre au moins une branche comprenant une capacité, une inductance, une résistance, ou une combinaison de ce qui précède.

De préférence, le deuxième sous-circuit est agencé pour relier le terminal de contact au potentiel de masse à travers une branche comprenant un composant résistif.

De manière préférée, l'agencement du premier sous-circuit peut être tel qu'un courant électrique n'y passe que dans une première direction et l'agencement du deuxième sous-circuit, parallèle au premier sous-circuit, peut être tel qu'un courant électrique n'y passe que dans une deuxième direction, opposée à la première direction.

Le deuxième sous-circuit peut préférentiellement comprendre une diode.

Le premier sous-circuit peut de préférence comprendre au moins une source lumineuse à élément semi-conducteur électroluminescent. Il peut de préférence s'agir d'une diode électroluminescente, LED.

De préférence, la diode du deuxième sous-circuit est montée en parallèle, et en sens opposé, à la source lumineuse à élément semi-conducteur électroluminescent.

De préférence, le deuxième sous-circuit comprenant un composant électronique destiné à s'auto-détruire au passage d'un courant électrique ayant au moins une intensité seuil prédéterminée.

De préférence, l'intensité seuil peut être inférieure à la l'intensité du courant de charge requise pour le fonctionnement de ladite fonction lumineuse.

De préférence, ledit composant électronique peut comprendre un composant résistif.

Le composant électronique peut de préférence comprendre un fusible.

De préférence, le composant électronique (F) peut comprend une piste conductrice du circuit imprimé. La piste peut de préférence avoir une section dimensionnée de manière à s'auto-détruire lors du passage d'un courant électrique ayant une intensité plus élevée que ladite intensité seuil.

Selon un autre aspect de l'invention, un module lumineux pour un véhicule automobile est proposé. Le module comprend une pluralité d'ensembles de connexion conformes à un quelconque aspect de l'invention. De préférence, le premier sous-circuit de chaque ensemble peut réaliser une fonction lumineuse distincte d'un même véhicule automobile.

De préférence, le deuxième sous-circuit de chaque ensemble de connexion peut présenter une résistance identique.

De préférence, le deuxième sous-circuit de chaque ensemble de connexion présente une résistance différente permettant l'identification de l'ensemble de connexion.

Selon un autre aspect de l'invention, un procédé de diagnostic de la connexion entre un connecteur et un circuit imprimé formant un ensemble de connexion selon un quelconque aspect de l'invention est proposé. Le procédé comprenant les étapes suivantes :
- mettre à disposition une connexion entre le connecteur et le circuit imprimé ;
- fournir un signal électrique de vérification, ayant des premières caractéristiques, au niveau du contact de vérification ;
- en utilisant un instrument de mesure mesurer un signal électrique de sortie du deuxième sous-circuit du circuit imprimé ;
- en utilisant une unité de traitement de données, comparer le signal de vérification et le signal de sortie, et conclure à une connexion correcte ou incorrecte en fonction du résultat de la comparaison.

Selon un autre aspect de l'invention, un procédé de diagnostic des connexions entre les connecteurs et circuits imprimés respectifs d'un module lumineux conforme à un aspect de l'invention. Le procédé comprenant les étapes suivantes :
- mettre à disposition une connexion entre les connecteurs et les circuits imprimés ;
- fournir un signal électrique de vérification, ayant des premières caractéristiques, au niveau du contact de vérification de chaque ensemble de connexion;
- en utilisant un instrument de mesure mesurer un signal électrique de sortie du deuxième sous-circuit du circuit imprimé de chaque ensemble de connexion;
- en utilisant une unité de traitement de données, comparer le signal de vérification et le signal de sortie, et conclure à une connexion correcte ou incorrecte des circuits imprimés en fonction du résultat de la comparaison.

De préférence, le module lumineux peut comprendre des deuxièmes sous-circuits présentant chacun une résistance identique, et le procédé peut comprendre l'étape supplémentaire de :
- en utilisant l'unité de traitement de données, déterminer le nombre de circuit imprimés correctement connectés en fonction du résultat de la comparaison.

De préférence, le module lumineux peut comprendre des deuxièmes sous-circuits présentant chacun une résistance distincte, et le procédé peut comprendre l'étape supplémentaire de :
- en utilisant l'unité de traitement de données, identifier les circuits imprimés correctement connectés en fonction du résultat de la comparaison.

L'instrument de mesure peut de préférence comprendre un ampèremètre, un voltmètre ou un Ohm-mètre.

L'unité de traitement de données peut de préférence comprendre un processeur de données configuré moyennant un logiciel approprié.

De préférence, ledit signal électrique de vérification peut comprendre un courant électrique ayant une intensité inférieure à ladite intensité seuil.

De préférence, le procédé peut comprendre une étape supplémentaire de représentation auditive et/ou visuelle de la conclusion par des moyens de sortie auditive et/visuelle. Il peut de préférence s'agir d'un haut-parleur ou d'un écran fonctionnellement relié audit processeur. La représentation visuelle peut de préférence comprendre un signal vert en cas de réussite de connexion, et un signal rouge en cas de défaillance de connexion.

Les aspects de l'invention proposent un ensemble de connexion électrique qui permet de vérifier la tenue d'un connecteur dans une prise moyennant un signal électrique de vérification, en utilisant un minimum de composants électroniques. En utilisant les mesures proposées par la présente invention il devient possible de s'assurer de la qualité d'une connexion électrique d'un harnais de connexion à un circuit imprimé lors de l'assemblage d'un module lumineux pour véhicule automobile. Ceci est facilité par exemple par un retour visuel sur la qualité de connexion, qui elle est réalisée à l'aveugle. Selon des modes de réalisation préférentiels de l'invention, l'ensemble de connexion et le procédé de diagnostic proposés font recours à un minimum de composants électroniques ajoutés, par rapport à un circuit imprimé fonctionnel n'étant pas apte à être diagnostiqué. Cette approche minimise le surcoût de production de la solution proposée.

D'autres caractéristiques et avantages de la présente invention seront mieux compris à l'aide de la description des exemples et des dessins parmi lesquels :
- La figure 1 montre de manière schématique un dispositif de connexion en accord avec un mode de réalisation préférentiel de l'invention ;
- La figure 2 montre une coupe à travers un connecteur et une prise qui lui correspond, connus dans l'état de l'art ;
- La figure 3 montre de manière schématique un dispositif de connexion en accord avec un mode de réalisation préférentiel de l'invention ;
- La figure 4 montre de manière schématique un dispositif de connexion en accord avec un mode de réalisation préférentiel de l'invention ;
- La figure 5 montre de manière schématique un dispositif de connexion en accord avec un mode de réalisation préférentiel de l'invention ;
- La figure 6 montre de manière schématique un dispositif de connexion en accord avec un mode de réalisation préférentiel de l'invention ;
- La figure 7 montre de manière schématique un dispositif de connexion en accord avec un mode de réalisation préférentiel de l'invention ;
- La figure 8 montre de manière schématique un dispositif de connexion en accord avec un mode de réalisation préférentiel de l'invention ;
- La figure 9 montre de manière schématique un dispositif de connexion en accord avec un mode de réalisation préférentiel de l'invention ;
- La figure 10 montre de manière schématique un dispositif de connexion en accord avec un mode de réalisation préférentiel de l'invention.
- La figure 11 montre de manière schématique un dispositif de connexion en accord avec un mode de réalisation préférentiel de l'invention.
- La figure 12 montre de manière schématique un dispositif de connexion en accord avec un mode de réalisation préférentiel de l'invention.

Sauf indication spécifique du contraire, des caractéristiques techniques décrites en détail pour un mode de réalisation donné peuvent être combinées aux caractéristiques techniques décrites dans le contexte d'autres modes de réalisation décrits à titre d'exemples et de manière non limitative. Des numéros de référence similaires seront utilisés pour décrire des concepts semblables à travers différents modes de réalisation de l'invention. Par exemple, les références 100, 200, 300 jusqu'à 1100 désignent onze modes de réalisation d'un ensemble de connexion selon l'invention.

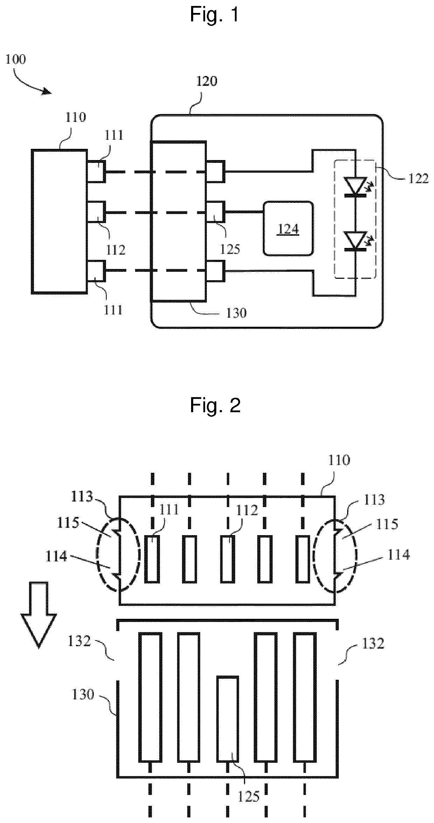

L'illustration de la figure 1 montre un ensemble de connexion électrique 100 selon un premier mode de réalisation préférentiel de l'invention. L'ensemble comprend un connecteur ou une fiche 110 qui marque typiquement la terminaison d'un harnais de connexion, et qui comprend une pluralité de contacts électriques 111, ainsi qu'un contact de vérification 112 destiné à la transmission d'un signal électrique de vérification de connexion électrique entre le connecteur et un circuit imprimé. L'ensemble 100 comprend également un circuit imprimé 120, par exemple de type PCB (« printed circuit board »), sans se limiter à cet exemple. Le circuit imprimé 120 comprend un premier sous-circuit électronique 122 qui participe activement à la réalisation d'une fonction lumineuse d'un véhicule automobile, bien que d'autres applications dans lesquelles l'ensemble de connexion proposé pourra être utile sont également envisageables. Dans l'exemple non-limitatif montré, le premier sous-circuit 122 comprend des diodes électroluminescentes, dont l'alimentation électrique est assurée par une différence de potentiel électrique fournie à leurs terminaux depuis un circuit d'alimentation électrique non-illustré. C'est le connecteur 110, moyennant les contacts électriques 111, qui permet de connecter la source d'alimentation au premier sous-circuit 122 du circuit imprimé 120. Le circuit imprimé 120 comprend en outre un deuxième sous-circuit électronique 124 dont les composants électroniques ne participent pas activement à la fonction lumineuse réalisée par le premier sous-circuit 122. La fonction principale du deuxième sous-circuit est de coopérer électriquement avec le contact de vérification, moyennant un terminal de contact 125 correspondant, lorsque le connecteur 110 est tenu par la prise 130 correspondante implantée sur le circuit imprimé 120.

Lors d'un procédé d'assemblage et notamment de connexion du harnais se terminant avec le connecteur 110 d'une part, au circuit imprimé 120 d'autre part, le diagnostic de connexion correcte est réalisé de la manière suivante. Suite à la connexion manuelle par un opérateur du connecteur 110 dans la prise 130, un signal électrique de vérification prédéterminé est fourni par un dispositif non-illustré sur le contact de vérification 112. Si la connexion est adéquate, le contact de vérification est en contact avec le terminal 125 du deuxième sous-circuit 124 du circuit imprimé, et le signal électrique subit un changement au passage par ce sous-circuit. Un dispositif de mesure non-illustré permet de mesurer l'allure du signal électrique ainsi modifié et conclure à ce que la connexion a réussi (le signal de vérification a été modifié de manière prédéterminée) ou échouée (le signal n'est pas passé dans le deuxième sous-circuit 124). De préférence, le dispositif de mesure est configuré, moyennant un processeur de données préconfiguré, pour fournir une notification visuelle ou auditive à l'opérateur moyennant une interface appropriée. La notification indique le résultat du test, ce qui permet à l'opérateur de refaire la connexion, le cas échéant. Alors que d'autres exemples sont possibles, le signal électrique de vérification comprend par exemple une tension électrique d'une intensité prédéterminée, qui subit une chute lorsque le courant électrique traverse le deuxième circuit 124 en cas de bonne connexion. Cette chute de potentiel électrique est mesurable par des moyens connus dans l'art.

La figure 2 montre un connecteur électrique 110 et une prise 130 qui correspond au connecteur. Ce dispositif est connu depuis l'état de l'art et peut être utilisé de manière non-limitative dans les modes de réalisation de la présente invention. Lors du branchement du connecteur dans la prise, leurs contacts respectifs entrent en contact mécanique et électrique. A cet effet il est par exemple avantageux qu'une paire des contacts complémentaires soit formée d'une part par un contact tubulaire creux et d'autre part par un contact filaire ayant un diamètre permettant de glisser en contact dans le contact tubulaire, permettant ainsi différents niveaux d'enfoncement. Le connecteur 110 comprend un châssis aux deux bords opposés latéraux duquel deux ergots, l'un distal 114 et l'autre proximal 115 sont formés. Ces ergots permettent de s'engager dans une structure de réception 132 ou ouverture correspondante du châssis de la prise 130. Si es ergots distaux 114 s'engagent dans la structure de réception, la connexion électrique d'un premier jeu de contacts 111, avec des contacts complémentaires de la prise ayant une première longueur, peut être assurée. Si les ergots proximaux 115 s'engagent également dans la structure de réception 132, la connexion du premier jeu de contacts 111 ainsi que du contact de vérification 112, qui entre en contact avec le contact correspondant plus court 125 de la prise, peut être assurée. L'espacement entre les ergots 114, 115 le long de la direction dans laquelle le châssis du connecteur 110 s'étend, est choisi de manière à correspondre à la différence de longueur entre les contacts usuels et le terminal de contact 125 de la prise 130. Le terminal de contact peut notamment constituer un contact de vérification de la prise. Alors que dans l'exemple montré tous les contacts de la prise ou du connecteur sont alignés, ceci n'est pas une limitation nécessaire. Les ergots 114, 115 et les moyens de réception correspondants du niveau de la prise 130 réalisent ainsi une structure d'enclenchement mécanique mutuel 113, 132, permettant de réaliser un premier enclenchement mécanique correspondant à un premier degré moindre d'enfoncement, et d'un deuxième enclenchement mécanique correspondant à un deuxième degré plus important d'enfoncement du connecteur 110 dans la prise 130. Les termes « moindre » et « plus important » étant relatifs, ils sont à comprendre relativement l'un par rapport à l'autre : avec le deuxième degré d'enfoncement, le connecteur est enfoncé plus loin ou plus profondément dans la prise qu'avec le premier degré d'enfoncement.

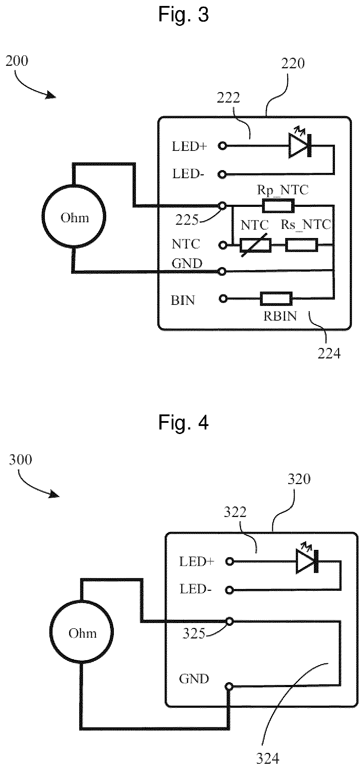

L'illustration de la figure 3 montre un ensemble de connexion électrique 200 selon un deuxième mode de réalisation préférentiel de l'invention. L'ensemble comprend un connecteur ou une fiche non-illustrée qui marque typiquement la terminaison d'un harnais de connexion, et qui comprend une pluralité de contacts électriques, ainsi qu'un contact de vérification destiné à la transmission d'un signal électrique de vérification de connexion électrique entre le connecteur et un circuit imprimé. L'ensemble 100 comprend également un circuit imprimé 220. Un premier sous-circuit électronique 222 comprend au moins une diode électroluminescente qui participe activement à la réalisation d'une fonction lumineuse d'un véhicule automobile. Le circuit imprimé 220 comprend en outre un deuxième sous-circuit électronique 224 dont les composants électroniques ne participent pas activement à la fonction lumineuse réalisée par le premier sous-circuit 222. Dans l'exemple montré, il s'agit d'un ensemble de composants résistifs, en occurrence un thermistor et un réseau de résistances. Ces composants peuvent avoir une fonction passive dans la calibration du courant électrique d'alimentation du premier sous-circuit 222 si leur température est représentative de la température de jonction semi-conductrice des diodes électroluminescentes. Un des contacts du connecteur permet de brancher le deuxième sous-circuit 224 au potentiel de masse GND, alors que le contact de vérification est connecté au terminal de contact 225 si le connecteur est tenu dans la prise.

Lors d'un procédé d'assemblage et notamment de connexion du harnais se terminant avec le connecteur d'une part, au circuit imprimé 220 d'autre part, le diagnostic de connexion correcte est réalisé de la manière suivante. Suite à la connexion manuelle par un opérateur du connecteur dans la prise du circuit imprimé 220, un courant électrique ayant une intensité prédéterminée, fourni par une source non-illustrée, par exemple par une batterie, est fourni sur le contact de vérification. Si la connexion est adéquate, le contact de vérification est en contact avec le terminal 225 du deuxième sous-circuit 122 du circuit imprimé, et la résistance des thermistors devient mesurable par un Ohm-mètre connecté aux contacts de vérification et GND respectivement du connecteur.

L'illustration de la figure 4 montre un ensemble de connexion électrique 300 selon un troisième mode de réalisation préférentiel de l'invention. L'ensemble comprend un connecteur ou une fiche non-illustrée qui marque typiquement la terminaison d'un harnais de connexion, et qui comprend une pluralité de contacts électriques, ainsi qu'un contact de vérification destiné à la transmission d'un signal électrique de vérification de connexion électrique entre le connecteur et un circuit imprimé. L'ensemble 300 comprend également un circuit imprimé 320. Un premier sous-circuit électronique 322 comprend au moins une diode électroluminescente qui participe activement à la réalisation d'une fonction lumineuse d'un véhicule automobile. Le circuit imprimé 320 comprend en outre un deuxième sous-circuit électronique 324 comprenant une piste électriquement conductrice et résistive. Un des contacts du connecteur permet de brancher le deuxième sous-circuit 324 au potentiel de masse GND, alors que le contact de vérification est connecté au terminal de contact 325 si le connecteur est tenu dans la prise.

Lors d'un procédé d'assemblage et notamment de connexion du harnais se terminant avec le connecteur d'une part, au circuit imprimé 320 d'autre part, le diagnostic de connexion correcte est réalisé de la manière suivante. Suite à la connexion manuelle par un opérateur du connecteur dans la prise du circuit imprimé 320, un courant électrique ayant une intensité prédéterminée, fourni par une source non-illustrée, par exemple par une batterie, est fourni sur le contact de vérification. Si la connexion est adéquate, le contact de vérification est en contact avec le terminal 325 du deuxième sous-circuit 322 du circuit imprimé, et la résistance des du sous-circuit devient mesurable par un Ohm-mètre connecté aux contacts de vérification et GND respectivement du connecteur.

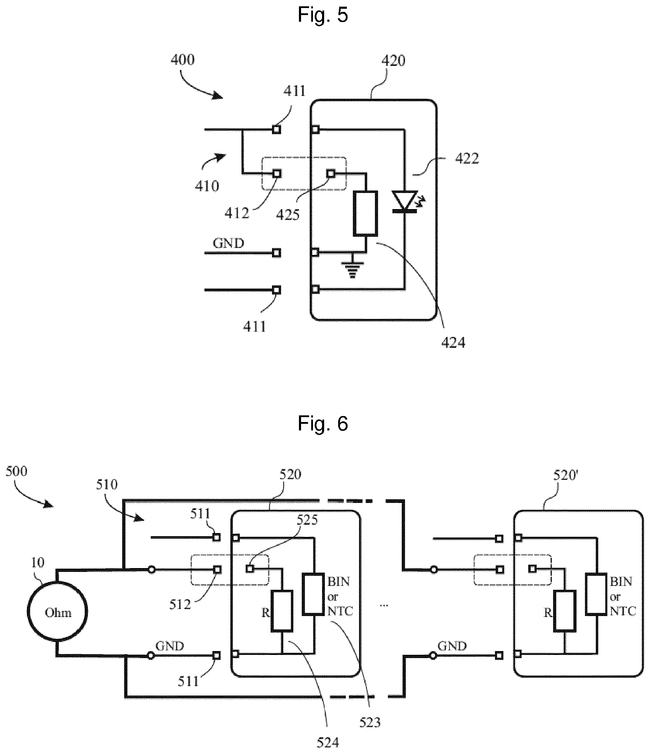

L'illustration de la figure 5 montre un ensemble de connexion électrique 400 selon un quatrième mode de réalisation préférentiel de l'invention. L'ensemble comprend un connecteur ou une fiche 410 qui marque typiquement la terminaison d'un harnais de connexion, et qui comprend une pluralité de contacts électriques 411, ainsi qu'un contact de vérification 412 destiné à la transmission d'un signal électrique de vérification de connexion électrique entre le connecteur et un circuit imprimé. Dans l'exemple montré, sur un des contacts 411 montré en haut de la figure, une épissure est réalisée pour générer le contact 412 au même potentiel électrique. L'ensemble 400 comprend également un circuit imprimé 420, par exemple de type PCB (« printed circuit board »), sans se limiter à cet exemple. Un premier sous-circuit électronique 422 comprend au moins une diode électroluminescente qui participe activement à la réalisation d'une fonction lumineuse d'un véhicule automobile. Le premier sous-circuit est alimenté par une différence de potentiel entre les contacts 411 du haut et du bas de figure respectivement. Le circuit imprimé 420 comprend en outre un deuxième sous-circuit électronique 424 dont les composants électroniques ne participent pas activement à la fonction lumineuse réalisée par le premier sous-circuit 422. Le deuxième sous-circuit comprend un terminal de contact 425 qui se raccorde au contact de vérification 412 en cas de connexion correcte entre le connecteur 410 dans la prise du circuit imprimé. Le deuxième sous-circuit est relié au potentiel de masse fourni par un des contacts du connecteur à travers une résistance. L'impédance du de la résistance est de préférence importante de l'ordre de plusieurs MΩ, afin de limiter le courant qui se dissipe dans ce sous-circuit.

Lors d'un procédé d'assemblage et notamment de connexion du harnais se terminant avec le connecteur 410 d'une part, au circuit imprimé 420 d'autre part, le diagnostic de connexion correcte est réalisé de la manière suivante. Suite à la connexion manuelle par un opérateur du connecteur 410 dans la prise non-illustrée du circuit imprimé, dans un premier temps, une première différence de potentiel est appliquée entre le contact 411 et donc également 412, et le potentiel de masse. Le potentiel sur le contact 411 est choisi de manière à ce que la différence de potentiel aux bornes du premier sous-circuit soit inférieur à la tension directe des diodes électroluminescentes. Comme la valeur de la résistance est connue, une mesure de la chute de tension entre les contacts 412 et GND permet de vérifier si la connexion a réussi. Suite à la connexion correcte et vérifiée du connecteur et du circuit imprimé, dans un deuxième temps correspondant au fonctionnement du module lumineux en question, le potentiel électrique appliqué au contact 411 est tel que la différence de potentiel aux bornes du premier sous-circuit 422 est suffisamment élevée pour qu'un courant électrique traverse les diodes électroluminescentes.

Après le diagnostic, un courant électrique de faible intensité circule dans le deuxième sous-circuit.

Il va de soi que d'autres configurations du deuxième sous-circuit 424 peuvent être prévues par l'homme du métier sans pour autant sortir du cadre de la présente invention. Ceci s'applique également aux autres modes de réalisation décrits dans le contexte d'un deuxième sous-circuit purement résistif. Le deuxième sous-circuit peut notamment comprendre un circuit RL, RC, LC ou RLC, connus dans l'art, pour autant que le signal électrique de vérification utilisé lors de la phase de diagnostic soit tel qu'il permette de détecter si le sous-circuit en question est alimenté ou non. Evidemment des instruments de mesure appropriés, tels qu'un voltmètre ou un ampèremètre peuvent être utilisés selon les besoins et les choix de sous-circuits effectués.

L'illustration de la figure 6 montre un ensemble de connexion électrique 500 selon un cinquième mode de réalisation préférentiel de l'invention. L'ensemble comprend un connecteur ou une fiche 510 qui marque typiquement la terminaison d'un harnais de connexion, et qui comprend une pluralité de contacts électriques 511, ainsi qu'un contact de vérification 512 destiné à la transmission d'un signal électrique de vérification de connexion électrique entre le connecteur et un circuit imprimé. L'ensemble 500 comprend également un circuit imprimé 520. Un premier sous-circuit électronique non-illustré participe activement à la réalisation d'une fonction lumineuse d'un véhicule automobile. Dans l'exemple montré, le circuit imprimé comprend en outre un sous-circuit 523 comprenant des composants électroniques qui participent de manière passive à la fonction lumineuse du véhicule automobile. Il s'agit par exemple d'une résistance RBIN ou d'un thermistor, dont la mesure est utile lors d'une phase de calibration du courant électrique d'alimentation de sources lumineuses. Le circuit imprimé 520 comprend en outre un deuxième sous-circuit électronique 524 dont les composants électroniques ne participent ni activement ni passivement à la fonction lumineuse. Le deuxième sous-circuit est indépendant des autres sous-circuits du circuit imprimé. Le deuxième sous-circuit comprend un terminal de contact 525 qui se raccorde au contact de vérification 512 en cas de connexion correcte entre le connecteur 510 dans la prise du circuit imprimé. Le deuxième sous-circuit est relié au potentiel de masse fourni par un des contacts du connecteur à travers une résistance d'une impédance prédéterminée.

Lors d'un procédé d'assemblage et notamment de connexion du harnais se terminant avec le connecteur 510 d'une part, au circuit imprimé 520 d'autre part, le diagnostic de connexion correcte est réalisé de la manière suivante. Suite à la connexion manuelle par un opérateur du connecteur 510 dans la prise non-illustrée du circuit imprimé, dans un premier temps, une première différence de potentiel est appliquée entre le contact 512, et le potentiel de masse. Comme la valeur de la résistance calibrée R est connue, une mesure de la chute de tension entre les contacts 512 et GND permet de vérifier si la connexion a réussi. Suite à la connexion correcte et vérifiée du connecteur et du circuit imprimé, dans un deuxième temps correspondant au fonctionnement du module lumineux en question, le contact de vérification 512 n'est plus alimenté et le potentiel électrique appliqué au contact 511 est tel que soit la valeur RBIN ou la résistance du thermistor peuvent être mesurées, soit tel que la différence de potentiel aux bornes du premier sous-circuit est suffisamment élevée pour qu'un courant électrique traverse les diodes électroluminescentes.

Après le diagnostic, aucun courant électrique ne circule plus dans le deuxième sous-circuit 524. D'autant plus, un seul fils de connexion peut être utilisé pour relier un instrument de mesure 10 en parallèle à une pluralité de circuits imprimée 520, 520' tels que montrés sur la figure 6. Si les valeurs des résistances calibrées R de tous les circuits imprimés 520, 520' sont identiques, la résistance équivalente vue par l'instrument de mesure est égale à R/n, ou n est le nombre de circuits imprimés en parallèle. L'instrument peut donc conclure et indiquer le nombre de connexions correctes. Alternativement, chaque circuit imprimé 520 possède une résistance R calibrée d'une valeur différente. Ainsi, l'instrument de mesure peut identifier par un calcul en soi connu dans l'art laquelle des connexions a échouée ou a réussie. Une notification auditive et/ou visuelle est alors générée.

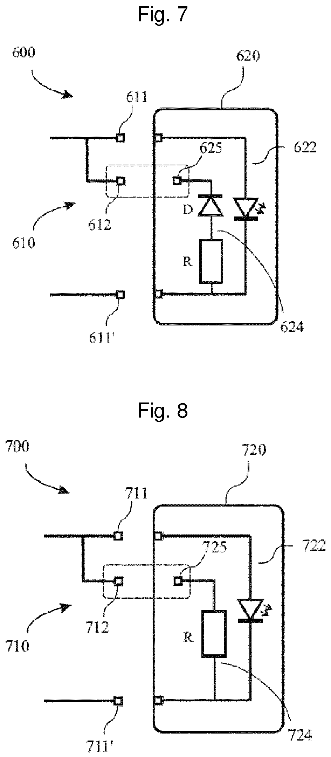

L'illustration de la figure 7 montre un ensemble de connexion électrique 600 selon un sixième mode de réalisation préférentiel de l'invention. L'ensemble comprend un connecteur ou une fiche 610 qui marque typiquement la terminaison d'un harnais de connexion, et qui comprend une pluralité de contacts électriques 611, 611' ainsi qu'un contact de vérification 612 destiné à la transmission d'un signal électrique de vérification de connexion électrique entre le connecteur et un circuit imprimé. Dans l'exemple montré, sur un des contacts 611 montré en haut de la figure, une épissure est réalisée pour générer le contact 612 au même potentiel électrique. L'ensemble 600 comprend également un circuit imprimé 620, par exemple de type PCB (« printed circuit board »), sans se limiter à cet exemple. Un premier sous-circuit électronique 622 comprend au moins une diode électroluminescente qui participe activement à la réalisation d'une fonction lumineuse d'un véhicule automobile. L'orientation dans un premier sens de la diode électroluminescente implique qu'un courant électrique ne peut traverser le premier sous-circuit que dans ce premier sens. Alternativement, une source lumineuse non semi-conductrice peut être montée en série avec une diode montée dans ce premier sens. Le premier sous-circuit est alimenté par une différence de potentiel entre les contacts 611 et 611'. Le circuit imprimé 620 comprend en outre un deuxième sous-circuit électronique 624 dont les composants électroniques ne participent pas activement à la fonction lumineuse réalisée par le premier sous-circuit 622. Le deuxième sous-circuit comprend un terminal de contact 625 qui se raccorde au contact de vérification 612 en cas de connexion correcte entre le connecteur 610 dans la prise du circuit imprimé. Le deuxième sous-circuit est relié au contact 611' à travers une diode D et une résistance R. La diode D est montée en sens-inverse par rapport aux diodes électroluminescentes du premier sous-circuit 622.

Lors d'un procédé d'assemblage et notamment de connexion du harnais se terminant avec le connecteur 610 d'une part, au circuit imprimé 620 d'autre part, le diagnostic de connexion correcte est réalisé de la manière suivante. Suite à la connexion manuelle par un opérateur du connecteur 610 dans la prise non-illustrée du circuit imprimé, dans un premier temps, une première différence de potentiel est appliquée entre le contact 611' et le contact de vérification 612, de manière à ce que la diode D laisse passer un courant électrique tandis que les diodes électroluminescentes du premier sous-circuits 622 bloquent son passage. Comme la valeur de la résistance est connue, une mesure de la chute de tension entre les contacts 611' et 612 permet de vérifier si la connexion a réussi. Suite à la connexion correcte et vérifiée du connecteur et du circuit imprimé, dans un deuxième temps correspondant au fonctionnement du module lumineux en question, le potentiel électrique appliqué entre le contact 611 et 611' est tel qu'un courant électrique traverse les diodes électroluminescentes alors que la diode D du deuxième sous-circuit s'oppose à son passage. Après le diagnostic, uniquement un faible courant électrique, correspondant à un courant de fuite de la diode D peut circuler dans le deuxième sous-circuit.

L'illustration de la figure 8 montre un ensemble de connexion électrique 700 selon un septième mode de réalisation préférentiel de l'invention. L'ensemble comprend un connecteur ou une fiche 710 qui marque typiquement la terminaison d'un harnais de connexion, et qui comprend une pluralité de contacts électriques 711, 711' ainsi qu'un contact de vérification 712 destiné à la transmission d'un signal électrique de vérification de connexion électrique entre le connecteur et un circuit imprimé. Dans l'exemple montré, sur un des contacts 711 montré en haut de la figure, une épissure est réalisée pour générer le contact 712 au même potentiel électrique. L'ensemble 700 comprend également un circuit imprimé 720. Un premier sous-circuit électronique 722 comprend au moins une diode électroluminescente qui participe activement à la réalisation d'une fonction lumineuse d'un véhicule automobile. Le premier sous-circuit est alimenté par une différence de potentiel entre les contacts 711 et 711'. Le circuit imprimé 720 comprend en outre un deuxième sous-circuit électronique 724 dont les composants électroniques ne participent pas activement à la fonction lumineuse réalisée par le premier sous-circuit 722. Le deuxième sous-circuit comprend un terminal de contact 725 qui se raccorde au contact de vérification 712 en cas de connexion correcte entre le connecteur 710 dans la prise du circuit imprimé. Le deuxième sous-circuit relie le contact de vérification 712 au contact 711' à travers une résistance calibrée d'une impédance importante, de l'ordre de quelques MΩ, afin de limiter le courant électrique qui se dissipe dans ce sous-circuit.

Lors d'un procédé d'assemblage et notamment de connexion du harnais se terminant avec le connecteur 710 d'une part, au circuit imprimé 720 d'autre part, le diagnostic de connexion correcte est réalisé de la manière suivante. Suite à la connexion manuelle par un opérateur du connecteur 710 dans la prise non-illustrée du circuit imprimé, dans un premier temps, une première différence de potentiel est appliquée entre le contact 711 et donc également 712 d'une part, et le contact 711' d'autre part. La différence de potentiel est choisie de manière à ce qu'elle soit inférieure à la tension directe des diodes électroluminescentes. Comme la valeur de la résistance est connue, une mesure de la chute de tension entre les contacts 712 et 711' permet de vérifier si la connexion a réussi. Suite à la connexion correcte et vérifiée du connecteur et du circuit imprimé, dans un deuxième temps correspondant au fonctionnement du module lumineux en question, la différence de potentiel électrique appliquée entre les contacts 711 et 711' est suffisamment élevée pour qu'un courant électrique traverse les diodes électroluminescentes. Après le diagnostic, un courant électrique de faible intensité circule dans le deuxième sous-circuit.

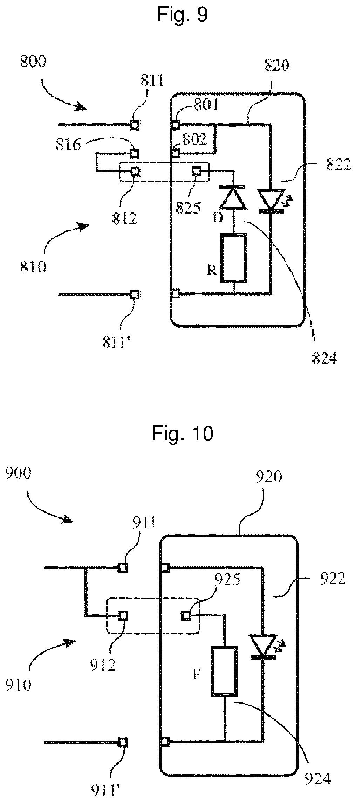

Le mode de réalisation de la figure 9 est similaire au mode de réalisation de la figure 7 et les mêmes numéros de référence s'appliquent en ajoutant 200 par instance. La différence entre les deux modes de réalisation se situe au niveau de l'épissure du contact 611. Dans le mode de réalisation, le contact correspondant 811 est connecté à un premier terminal 801, qui lui est relié par une piste électriquement conductrice du circuit imprimé 820 à un deuxième terminal 802. Le deuxième terminal est en contact avec un connecteur 816 du connecteur 810, qui est court-circuité sur le contact de vérification 812. Cet agencement permet de réaliser le contact de vérification 812 au potentiel identique porté par le contact 811 sans avoir recours à une épissure. Cette alternative de connexion s'applique à tous les modes de réalisation décrits qui font intervenir une épissure au niveau du contact de vérification.

L'illustration de la figure 10 montre un ensemble de connexion électrique 900 selon un neuvième mode de réalisation préférentiel de l'invention. L'ensemble comprend un connecteur ou une fiche 910 qui marque typiquement la terminaison d'un harnais de connexion, et qui comprend une pluralité de contacts électriques 911, 911' ainsi qu'un contact de vérification 912 destiné à la transmission d'un signal électrique de vérification de connexion électrique entre le connecteur et un circuit imprimé. Dans l'exemple montré, sur un des contacts 911 montré en haut de la figure, une épissure est réalisée pour générer le contact 912 au même potentiel électrique. L'ensemble 900 comprend également un circuit imprimé 920, par exemple de type PCB (« printed circuit board »), sans se limiter à cet exemple. Un premier sous-circuit électronique 922 comprend au moins une diode électroluminescente qui participe activement à la réalisation d'une fonction lumineuse d'un véhicule automobile. Le premier sous-circuit est alimenté par une différence de potentiel entre les contacts 911 et 911'. Le circuit imprimé 920 comprend en outre un deuxième sous-circuit électronique 924 dont les composants électroniques ne participent pas activement à la fonction lumineuse réalisée par le premier sous-circuit 922. Le deuxième sous-circuit comprend un terminal de contact 925 qui se raccorde au contact de vérification 912 en cas de connexion correcte entre le connecteur 910 dans la prise du circuit imprimé. Le deuxième sous-circuit est relié au du contact 911' à travers un élément fusible F. Il s'agit de préférence d'un composant fusible calibré qui s'auto-détruit lorsqu'il est traversé par un courant électrique d'une intensité prédéterminée. En alternative, il peut s'agir d'une piste conductrice très fine du circuit-imprimé, qui s'auto-détruit par surchauffe au passage d'un courant électrique d'une intensité prédéterminée.

Lors d'un procédé d'assemblage et notamment de connexion du harnais se terminant avec le connecteur 910 d'une part, au circuit imprimé 920 d'autre part, le diagnostic de connexion correcte est réalisé de la manière suivante. Suite à la connexion manuelle par un opérateur du connecteur 910 dans la prise non-illustrée du circuit imprimé, dans un premier temps, une première différence de potentiel d'une valeur faible est appliquée entre le contact de vérification 912 et le contact 911', de manière à ce qu'un courant électrique d'une première intensité faible, par exemple de l'ordre de quelques mA, passe par le deuxième sous-circuit 924. Pour des intensités de courant basses, le fusible agit comme une résistance et une mesure de la chute de tension entre les contacts 912 et 911' lors de cette phase permet de conclure à une bonne connexion. Suite à la connexion correcte et vérifiée du connecteur et du circuit imprimé, dans un deuxième temps correspondant au fonctionnement du module lumineux en question, le potentiel électrique appliqué entre le contact 911 et 911' est tel qu'un courant électrique traverse les diodes électroluminescentes. Lors du premier fonctionnement de la fonction lumineuse, une deuxième différence de potentiel de valeur importante et au moins égale à la tension directe des diodes électroluminescentes du premier sous-circuit est appliquée entre les contacts 911 et 911'. Vu le montage, la même différence de potentiel est appliquée entre le contact de vérification 912 et le contact 911'. Il s'ensuit qu'un courant électrique d'une deuxième intensité plus élevée traverse le fusible F. Ce dernier est calibré de manière à se détruire au passage d'un courant électrique ayant une intensité seuil située en-dessous du courant ainsi généré. Le fusible se détruit lors du premier fonctionnement du module lumineux. Alternativement, à la fin du diagnostic, on peut volontairement faire passer un courant électrique d'intensité élevée, pour détruire le fusible indépendamment du premier fonctionnement du module lumineux. Après le diagnostic, aucun courant électrique ne peut plus circuler dans le deuxième sous-circuit qui a été ouvert par la destruction du composant fusible.

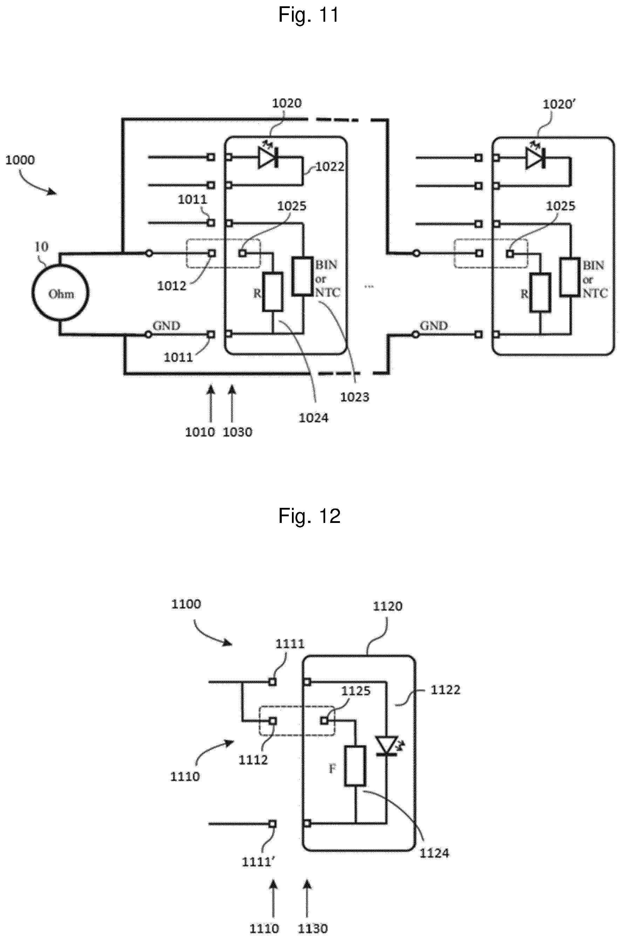

L'illustration de la figure 11 montre un ensemble de connexion électrique 1000 selon un dixième mode de réalisation préférentiel de l'invention. L'ensemble comprend un connecteur ou une fiche 1010 qui marque typiquement la terminaison d'un harnais de connexion, et qui comprend une pluralité de contacts électriques 1011, ainsi qu'un contact de vérification 1012 destiné à la transmission d'un signal électrique de vérification de connexion électrique entre le connecteur et un circuit imprimé. L'ensemble 1000 comprend également un circuit imprimé 1020, par exemple de type PCB (« printed circuit board »), sans se limiter à cet exemple. Le circuit imprimé 1020 comprend un premier sous-circuit électronique 1022 qui participe activement à la réalisation d'une fonction lumineuse d'un véhicule automobile, bien que d'autres applications dans lesquelles l'ensemble de connexion proposé pourra être utile sont également envisageables. Dans l'exemple non-limitatif montré, le premier sous-circuit 1022 comprend au moins une diode électroluminescente, dont l'alimentation électrique est assurée par une différence de potentiel électrique fournie à leurs terminaux depuis un circuit d'alimentation électrique non-illustré. C'est le connecteur 1010, moyennant les contacts électriques 1011, qui permet de connecter la source d'alimentation au premier sous-circuit 1022 du circuit imprimé 1020. Le circuit imprimé 1020 comprend en outre un deuxième sous-circuit électronique 1024 dont les composants électroniques ne participent pas activement à la fonction lumineuse réalisée par le premier sous-circuit 1022. La fonction principale du deuxième sous-circuit est de coopérer électriquement avec le contact de vérification, moyennant un terminal de contact 1025 correspondant, lorsque le connecteur 1010 est tenu par la prise 1030 correspondante implantée sur le circuit imprimé 1020. Le deuxième sous-circuit comprend un terminal de contact 1025 qui se raccorde au contact de vérification 1012 en cas de connexion correcte entre le connecteur 1010 dans la prise 1030 du circuit imprimé. Le deuxième sous-circuit est relié au potentiel de masse fourni par un des contacts du connecteur à travers une résistance d'une impédance prédéterminée.

Comme montré sur la figure 11, un module lumineux pour un véhicule automobile peut comprendre une pluralité 1020, 1020' de tels ensembles de connexion. Dans un mode de réalisation préféré, chacun des ensembles de connexion comprend un deuxième sous-circuit 1024 ayant la même résistance calibrée R. Alternativement, chacun des ensembles de connexion comprend un deuxième sous-circuit ayant un résistance calibrée distincte. Dans ce dernier cas, la résistance, et plus précisément la chute de tension aux bords de la résistance, permet d'identifier l'ensemble de connexion en question.

Il va de soi que le deuxième sous-circuit peut comprendre des montages plus complexes tels que des circuits RL, RC, RLC ou autres, pour autant que leur comportement électrique soit prédéterminé.

Dans l'exemple non-limitatif montré, le circuit imprimé 1020 comprend en outre un sous-circuit 1023 comprenant des composants électroniques qui participent de manière passive à la fonction lumineuse du véhicule automobile. Il s'agit par exemple d'une résistance RBIN ou d'un thermistor, dont la mesure est utile lors d'une phase de calibration du courant électrique d'alimentation de sources lumineuses. Le deuxième sous-circuit est indépendant des autres sous-circuits du circuit imprimé.

Lors d'un procédé d'assemblage et notamment de connexion du harnais se terminant avec le connecteur 1010 d'une part, au circuit imprimé 1020 d'autre part, le diagnostic de connexion correcte est réalisé de la manière suivante. Suite à la connexion manuelle par un opérateur du connecteur 1010 dans la prise 1030, un signal électrique de vérification prédéterminé est fourni par un dispositif non-illustré sur le contact de vérification 1012. Si la connexion est adéquate, le contact de vérification est en contact avec le terminal 1025 du deuxième sous-circuit 1024 du circuit imprimé, et le signal électrique subit un changement au passage par ce sous-circuit. Un dispositif de mesure 10 permet de mesurer l'allure du signal électrique ainsi modifié et conclure à ce que la connexion a réussi (le signal de vérification a été modifié de manière prédéterminée) ou échouée (le signal n'est pas passé dans le deuxième sous-circuit 1024). De préférence, le dispositif de mesure est configuré, moyennant un processeur de données préconfiguré, pour fournir une notification visuelle ou auditive à l'opérateur moyennant une interface appropriée. La notification indique le résultat du test, ce qui permet à l'opérateur de refaire la connexion, le cas échéant. Alors que d'autres exemples sont possibles, le signal électrique de vérification comprend par exemple une tension électrique d'une intensité prédéterminée, qui subit une chute lorsque le courant électrique traverse le deuxième circuit 1024 en cas de bonne connexion. Cette chute de potentiel électrique est mesurable par des moyens connus dans l'art.

De préférence, suite à la connexion manuelle par un opérateur du connecteur 1010 dans la prise du circuit imprimé, dans un premier temps, une première différence de potentiel est appliquée entre le contact 1012, et le potentiel de masse. Comme la valeur de la résistance calibrée R est connue, une mesure de la chute de tension entre les contacts 1012 et GND permet de vérifier si la connexion a réussi. Suite à la connexion correcte et vérifiée du connecteur et du circuit imprimé, dans un deuxième temps correspondant au fonctionnement du module lumineux en question, le contact de vérification 1012 n'est plus alimenté et le potentiel électrique appliqué au contact 1011 est tel que soit la valeur RBIN ou la résistance du thermistor peuvent être mesurées, soit tel que la différence de potentiel aux bornes du premier sous-circuit est suffisamment élevée pour qu'un courant électrique traverse les diodes électroluminescentes.

Après le diagnostic, aucun courant électrique ne circule plus dans le deuxième sous-circuit 1024. D'autant plus, un seul fils de connexion peut être utilisé pour relier un instrument de mesure 10 en parallèle à une pluralité de circuits imprimés 1020, 1020' d'un module lumineux, tels que montrés sur la figure 2. Si les valeurs des résistances calibrées R de tous les circuits imprimés 1020, 1020' sont identiques, la résistance équivalente vue par l'instrument de mesure est égale à R/n, ou n est le nombre de circuits imprimés en parallèle. L'instrument peut donc conclure et indiquer le nombre de connexions correctes. Alternativement, chaque circuit imprimé 1020, 1020' possède une résistance R calibrée d'une valeur différente. Ainsi, l'instrument de mesure peut identifier par un calcul en soi connu dans l'art laquelle des connexions a échouée ou a réussie. Une notification auditive et/ou visuelle est alors générée.

L'illustration de la figure 12 montre un ensemble de connexion électrique 1100 selon un onzième mode de réalisation préférentiel de l'invention. L'ensemble comprend un connecteur ou une fiche 1110 qui marque typiquement la terminaison d'un harnais de connexion, et qui comprend une pluralité de contacts électriques 1111, 1111' ainsi qu'un contact de vérification 1112 destiné à la transmission d'un signal électrique de vérification de connexion électrique entre le connecteur et un circuit imprimé. L'ensemble 1100 comprend également un circuit imprimé 1120, par exemple de type PCB (« printed circuit board »), sans se limiter à cet exemple. Le circuit imprimé 1120 comprend un premier sous-circuit électronique 1122 qui participe activement à la réalisation d'une fonction lumineuse d'un véhicule automobile, bien que d'autres applications dans lesquelles l'ensemble de connexion proposé pourra être utile sont également envisageables. Dans l'exemple non-limitatif montré, le premier sous-circuit 1122 comprend des diodes électroluminescentes, dont l'alimentation électrique est assurée par une différence de potentiel électrique fournie à leurs terminaux depuis un circuit d'alimentation électrique non-illustré. C'est le connecteur 1110, moyennant les contacts électriques 1111, qui permet de connecter la source d'alimentation au premier sous-circuit 1122 du circuit imprimé 1120. Le circuit imprimé 1120 comprend en outre un deuxième sous-circuit électronique 1124 dont les composants électroniques ne participent pas activement à la fonction lumineuse réalisée par le premier sous-circuit 1122. La fonction principale du deuxième sous-circuit est de coopérer électriquement avec le contact de vérification, moyennant un terminal de contact 1125 correspondant, lorsque le connecteur 1110 est tenu par la prise 1130 correspondante implantée sur le circuit imprimé 1120.

Dans l'exemple montré, sur un des contacts 1111 montré en haut de la figure, une épissure est réalisée pour générer le contact 1112 au même potentiel électrique. Tout autre agencement ayant pour effet de reprendre le potentiel du contact 1111 sur le contact de vérification 1112 est censé être équivalent. Le premier sous-circuit est alimenté par une différence de potentiel entre les contacts 1111 et 1111'. Le deuxième sous-circuit comprend un terminal de contact 1125 qui se raccorde au contact de vérification 1112 en cas de connexion correcte entre le connecteur 1110 dans la prise 1130 du circuit imprimé. Le deuxième sous-circuit est relié au du contact 1111' à travers un élément fusible F. Il s'agit de préférence d'un composant fusible calibré qui s'auto-détruit lorsqu'il est traversé par un courant électrique d'une intensité prédéterminée. En alternative, il peut s'agir d'une piste conductrice très fine du circuit-imprimé ou d'un composant résistif qui s'auto-détruit par surchauffe au passage d'un courant électrique d'une intensité prédéterminée.

Lors d'un procédé d'assemblage et notamment de connexion du harnais se terminant avec le connecteur 1110 d'une part, au circuit imprimé 1120 d'autre part, le diagnostic de connexion correcte est réalisé de la manière suivante. Suite à la connexion manuelle par un opérateur du connecteur 1110 dans la prise 1130, un signal électrique de vérification prédéterminé est fourni par un dispositif non-illustré sur le contact de vérification 1112. Si la connexion est adéquate, le contact de vérification est en contact avec le terminal 1125 du deuxième sous-circuit 1124 du circuit imprimé, et le signal électrique subit un changement au passage par ce sous-circuit. Un dispositif de mesure non-illustré permet de mesurer l'allure du signal électrique ainsi modifié et conclure à ce que la connexion a réussi (le signal de vérification a été modifié de manière prédéterminée) ou échouée (le signal n'est pas passé dans le deuxième sous-circuit 1124). De préférence, le dispositif de mesure est configuré, moyennant un processeur de données préconfiguré, pour fournir une notification visuelle ou auditive à l'opérateur moyennant une interface appropriée. La notification indique le résultat du test, ce qui permet à l'opérateur de refaire la connexion, le cas échéant. Alors que d'autres exemples sont possibles, le signal électrique de vérification comprend par exemple une tension électrique d'une intensité prédéterminée, qui subit une chute lorsque le courant électrique traverse le deuxième circuit 1124 en cas de bonne connexion. Cette chute de potentiel électrique est mesurable par des moyens connus dans l'art.

De manière plus spécifique, suite à la connexion manuelle par un opérateur du connecteur 1110 dans la prise 1130 du circuit imprimé 1120, dans un premier temps, une première différence de potentiel d'une valeur faible est appliquée entre le contact de vérification 1112 et le contact 1111', de manière à ce qu'un courant électrique d'une première intensité faible, par exemple de l'ordre de quelques mA, passe par le deuxième sous-circuit 1124. Pour des intensités de courant basses, le fusible agit comme une résistance et une mesure de la chute de tension entre les contacts 1112 et 1111' lors de cette phase permet de conclure à une bonne connexion. Le courant électrique n'a pas une intensité suffisante au fonctionnement des sources lumineuses du premier sous-circuit 1122. Par exemple, il est inférieur à la valeur du courant de charge des diodes électroluminescentes du premier sous-circuit 1122. Suite à la connexion correcte et vérifiée du connecteur et du circuit imprimé, dans un deuxième temps correspondant au fonctionnement du module lumineux en question, le potentiel électrique appliqué entre le contact 1111 et 1111' est tel qu'un courant électrique d'intensité plus importante traverse les diodes électroluminescentes. Lors du premier fonctionnement de la fonction lumineuse, une deuxième différence de potentiel de valeur importante et au moins égale à la tension directe des diodes électroluminescentes du premier sous-circuit est appliquée entre les contacts 1111 et 1111'. Vu le montage, la même différence de potentiel est appliquée entre le contact de vérification 1112 et le contact 1111'. Il s'ensuit qu'un courant électrique d'une deuxième intensité plus élevée et supérieure à la valeur seuil d'autodestruction traverse le composant fusible F. Ce dernier est calibré de manière à se détruire au passage d'un courant électrique ayant une intensité seuil située en-dessous du courant ainsi généré. Le fusible se consomme lors du premier fonctionnement du module lumineux. Après le diagnostic, aucun courant électrique ne peut plus circuler dans le deuxième sous-circuit qui a été ouvert par la destruction du composant fusible.

Dans tous les modes de réalisation, un dispositif de diagnostic, comprenant un instrument de mesure ainsi qu'un dispositif de retour auditif et/ou visuel tel qu'un haut-parleur et/ou un écran peut être prévu pour implémenter le procédé de diagnostic. De préférence, il s'agit d'un ordinateur ayant des interfaces correspondantes, un élément de mémoire ainsi qu'un processeur programmé pour réaliser les différentes étapes décrite dans chaque mode de réalisation. De préférence, le dispositif de diagnostic est connecté aux différents circuits imprimés pour lesquels la connexion au connecteur respectif est à tester, sans passer par des circuits de pilotage de l'alimentation électrique desdits circuits imprimés.

Il va de soi que les modes de réalisation décrits ne limitent pas l'étendue de la protection de l'invention.

L'étendue de la protection est déterminée par les revendications.

## Revendications

1. Ensemble de connexion électrique (100, 200, 300, 400, 500, 600, 700, 800, 900, 1000, 1100) comprenant un connecteur (110, 410, 510, 610, 710, 810, 910, 1010, 1110) et un circuit imprimé (120, 220, 320, 420, 520, 620, 720, 820, 920, 1020, 1120) qui comprend une prise (130, 1030, 1130) correspondant au connecteur et un premier sous-circuit électronique (122, 222, 322, 422, 522, 622, 722, 822, 922, 1022, 1122) participant à la réalisation d'une fonction lumineuse d'un véhicule automobile, le connecteur comprenant une pluralité de contacts électriques (111, 411, 511, 611, 711, 811, 911, 1011, 1111), le connecteur, moyennant les contacts électriques, permettant de connecter une source d'alimentation au premier sous-circuit du circuit imprimé,
**caractérisé en ce que** le connecteur comprend en outre un contact de vérification (112, 412, 512, 612, 712, 812, 912, 1012, 1112) destiné à la transmission d'un signal électrique de vérification de la connexion électrique entre le connecteur et le circuit imprimé, dans lequel le circuit imprimé comprend un deuxième sous-circuit (124, 224, 324, 424, 524, 624, 724, 824, 924, 1024, 1124) ayant un terminal de contact (125, 225, 325, 425, 525, 625, 725, 825, 925, 1025, 1125) destiné à être relié audit contact de vérification en cas de tenue du connecteur dans la prise, de sorte que le signal électrique subisse un changement au passage par le deuxième sous-circuit.

2. Ensemble de connexion selon la revendication 1, **caractérisé en ce que** le connecteur et la prise comprennent une structure d'enclenchement mécanique mutuel (113, 132), qui permet la réalisation d'un premier enclenchement mécanique correspondant à un premier degré moindre, et d'un deuxième enclenchement mécanique correspondant à un deuxième degré plus important d'enfoncement du connecteur dans la prise, et **en ce que** l'agencement du contact de vérification (112) et du terminal de contact du deuxième sous-circuit (125) est tel qu'ils sont en contact électrique si le deuxième enclenchement mécanique de la structure est engagé.

3. Ensemble de connexion selon une des revendications 1 ou 2, **caractérisé en ce que** la prise comprend une pluralité de contacts s'étendant sur une première longueur, et **en ce que** le terminal de contact (425, 525, 625, 725, 825, 925, 1025, 1125) s'étend sur une deuxième longueur plus courte.

4. Ensemble de connexion selon une des revendications 1 à 3, **caractérisé en ce que** le premier sous-circuit comprend au moins une source lumineuse à élément semi-conducteur électroluminescent.

5. Ensemble de connexion selon une des revendications 1 à 4, **caractérisé en ce que** le deuxième sous-circuit (224, 324, 424, 524) est agencé de manière à être relié au potentiel de masse, lorsque le connecteur est enfiché dans la prise.

6. Ensemble de connexion selon la revendication 5, **caractérisé en ce que** le deuxième sous-circuit est agencé pour relier le terminal de contact au potentiel de masse à travers au moins une branche qui comprend une capacité, une inductance, une résistance, ou une combinaison de ce qui précède.

7. Ensemble de connexion selon une des revendications 1 à 4, **caractérisé en ce que** le connecteur comprend un premier contact (611, 711, 811, 911) destiné à fournir un premier potentiel électrique non-nul au premier sous-circuit, et un deuxième contact (611', 711', 811', 911') destiné à fournir un deuxième potentiel électrique non-nul au premier sous-circuit, et **en ce que** l'agencement est tel que le terminal de contact (625, 725, 825, 925) est relié au premier potentiel électrique lorsque le connecteur est enfiché dans la prise.

8. Ensemble de connexion selon la revendication 7, **caractérisé en ce que** le deuxième sous-circuit est relié au deuxième potentiel électrique lorsque le connecteur est enfiché dans la prise.

9. Ensemble de connexion selon la revendication 8, **caractérisé en ce que** le deuxième sous-circuit comprend au moins une branche comprenant une capacité, une inductance, une résistance ou une combinaison de ce qui précède.

10. Ensemble de connexion selon une des revendications 8 ou 9, **caractérisé en ce que** le deuxième sous-circuit comprend un fusible.

11. Ensemble de connexion selon une des revendications 1 à 4, **caractérisé en ce que** le deuxième sous-circuit (1024) est agencé pour relier le terminal de contact au potentiel de masse à travers une branche comprenant un composant résistif, et optionnellement, qui comprend en outre une capacité, une inductance, une résistance, ou une combinaison de ce qui précède.

12. Ensemble de connexion selon une des revendications 1 à 4, **caractérisé en ce que** le deuxième sous-circuit comprend un composant électronique (F) destiné à s'auto-détruire au passage d'un courant électrique ayant au moins une intensité seuil prédéterminée.

13. Module lumineux pour un véhicule automobile, comprenant une pluralité d'ensembles de connexion selon la revendication 11.

14. Procédé de diagnostic de la connexion entre un connecteur et un circuit imprimé formant un ensemble de connexion selon l'une quelconque des revendications 1 à 12, le procédé comprenant les étapes suivantes :
- mettre à disposition une connexion entre le connecteur et le circuit imprimé ;
- fournir un signal électrique de vérification, ayant des premières caractéristiques, au niveau du contact de vérification ;
- en utilisant un instrument de mesure mesurer un signal électrique de sortie du deuxième sous-circuit du circuit imprimé ;
- en utilisant une unité de traitement de données, comparer le signal de vérification et le signal de sortie, et conclure à une connexion correcte ou incorrecte en fonction du résultat de la comparaison.

15. Procédé de diagnostic des connexions entre les connecteurs et circuits imprimés respectifs d'un module lumineux selon la revendication 13, comprenant les étapes suivantes :
- mettre à disposition une connexion entre les connecteurs et les circuits imprimés ;
- fournir un signal électrique de vérification, ayant des premières caractéristiques, au niveau du contact de vérification de chaque ensemble de connexion ;
- en utilisant un instrument de mesure mesurer un signal électrique de sortie du deuxième sous-circuit de chaque circuit imprimé ;
- en utilisant une unité de traitement de données, comparer le signal de vérification et le signal de sortie, et conclure à une connexion correcte ou incorrecte des circuits imprimés en fonction du résultat de la comparaison.

## Patentansprüche

1. Elektrisches Verbindungsensemble (100, 200, 300, 400, 500, 600, 700, 800, 900, 1000, 1100), umfassend einen Steckverbinder (110, 410, 510, 610, 710, 810, 910, 1010, 1110) und eine Leiterplatte (120, 220, 320, 420, 520, 620, 720, 820, 920, 1020, 1120), die eine dem Steckverbinder entsprechende Buchse (130, 1030, 1130) und einen ersten elektronischen Teilschaltkreis (122, 222, 322, 422, 522, 622, 722, 822, 922, 1022, 1122) umfasst, der an der Realisierung einer Lichtfunktion eines Kraftfahrzeugs beteiligt ist, wobei der Steckverbinder eine Vielzahl von elektrischen Kontakten (111, 411, 511, 611, 711, 811, 911, 1011, 1111) umfasst, wobei der Steckverbinder mittels der elektrischen Kontakte die Verbindung einer Stromversorgungsquelle mit dem ersten Teilschaltkreis der Leiterplatte ermöglicht,
**dadurch gekennzeichnet, dass** der Steckverbinder ferner einen Prüfkontakt (112, 412, 512, 612, 712, 812, 912, 1012, 1112) zur Übertragung eines elektrischen Prüfsignals der elektrischen Verbindung zwischen dem Steckverbinder und der Leiterplatte umfasst, wobei die Leiterplatte einen zweiten Teilschaltkreis (124, 224, 324, 424, 524, 624, 724, 824, 924, 1024, 1124) mit einem Kontaktanschluss (125, 225, 325, 425, 525, 625, 725, 825, 925, 1025, 1125) umfasst, der dazu bestimmt ist, mit dem Prüfkontakt verbunden zu werden, wenn der Steckverbinder in der Buchse gehalten wird, sodass das elektrische Signal beim Durchlaufen des zweiten Teilschaltkreises eine Änderung erfährt.

2. Verbindungsensemble nach Anspruch 1, **dadurch gekennzeichnet, dass** der Steckverbinder und die Buchse eine Struktur zum gegenseitigen mechanischen Einrasten (113, 132) umfassen, die die Realisierung eines ersten mechanischen Einrastens entsprechend einem ersten geringeren Grad und eines zweiten mechanischen Einrastens entsprechend einem zweiten höheren Grad des Einsteckens des Steckverbinders in die Buchse ermöglicht, und dass die Anordnung des Prüfkontakts (112) und des Kontaktanschlusses des zweiten Teilschaltkreises (125) derart ist, dass sie in elektrischem Kontakt stehen, wenn das zweite mechanische Einrasten der Struktur eingerastet ist.

3. Verbindungsensemble nach einem der Ansprüche 1 oder 2, **dadurch gekennzeichnet, dass** die Buchse eine Vielzahl von Kontakten umfasst, die sich über eine erste Länge erstrecken, und dass sich der Kontaktanschluss (425, 525, 625, 725, 825, 925, 1025, 1125) über eine zweite kürzere Länge erstreckt.

4. Verbindungsensemble nach einem der Ansprüche 1 bis 3, **dadurch gekennzeichnet, dass** der erste Teilschaltkreis mindestens eine Lichtquelle mit einem elektrolumineszenten Halbleiterelement umfasst.

5. Verbindungsensemble nach einem der Ansprüche 1 bis 4, **dadurch gekennzeichnet, dass** der zweite Teilschaltkreis (224, 324, 424, 524) so angeordnet ist, dass er mit dem Massepotenzial verbunden wird, wenn der Steckverbinder in die Buchse gesteckt wird.

6. Verbindungsensemble nach Anspruch 5, **dadurch gekennzeichnet, dass** der zweite Teilschaltkreis dazu eingerichtet ist, den Kontaktanschluss über mindestens einen Zweig, der eine Kapazität, eine Induktivität, einen Widerstand oder eine Kombination des Vorstehenden umfasst, mit dem Massepotenzial zu verbinden.

7. Verbindungsensemble nach einem der Ansprüche 1 bis 4, **dadurch gekennzeichnet, dass** der Steckverbinder einen ersten Kontakt (611, 711, 811, 911) zur Bereitstellung eines ersten nicht-null elektrischen Potenzials für den ersten Teilschaltkreis und einen zweiten Kontakt (611', 711', 811', 911') zur Bereitstellung eines zweiten nicht-null elektrischen Potenzials für den ersten Teilschaltkreis umfasst, und dass die Anordnung derart ist, dass der Kontaktanschluss (625, 725, 825, 925) mit dem ersten elektrischen Potenzial verbunden wird, wenn der Steckverbinder in die Buchse gesteckt wird.

8. Verbindungsensemble nach Anspruch 7, **dadurch gekennzeichnet, dass** der zweite Teilschaltkreis mit dem zweiten elektrischen Potenzial verbunden wird, wenn der Steckverbinder in die Buchse gesteckt wird.

9. Verbindungsensemble nach Anspruch 8, **dadurch gekennzeichnet, dass** der zweite Teilschaltkreis mindestens einen Zweig umfasst, der eine Kapazität, eine Induktivität, einen Widerstand oder eine Kombination des Vorstehenden umfasst.

10. Verbindungsensemble nach einem der Ansprüche 8 oder 9, **dadurch gekennzeichnet, dass** der zweite Teilschaltkreis eine Sicherung umfasst.

11. Verbindungsensemble nach einem der Ansprüche 1 bis 4, **dadurch gekennzeichnet, dass** der zweite Teilschaltkreis (1024) dazu eingerichtet ist, den Kontaktanschluss über einen Zweig, der ein resistives Bauelement umfasst, und optional ferner eine Kapazität, eine Induktivität, einen Widerstand oder eine Kombination des Vorstehenden umfasst, mit dem Massepotenzial zu verbinden.

12. Verbindungsensemble nach einem der Ansprüche 1 bis 4, **dadurch gekennzeichnet, dass** der zweite Teilschaltkreis ein elektronisches Bauelement (F) umfasst, das dazu bestimmt ist, sich beim Durchfluss eines elektrischen Stroms mit mindestens einer vorbestimmten Schwellstromstärke selbst zu zerstören.

13. Lichtmodul für ein Kraftfahrzeug, umfassend eine Vielzahl von Verbindungsensembles nach Anspruch 11.

14. Verfahren zur Diagnose der Verbindung zwischen einem Steckverbinder und einer Leiterplatte, die ein Verbindungsensemble nach einem der Ansprüche 1 bis 12 bilden, wobei das Verfahren die folgenden Schritte umfasst:
- Bereitstellen einer Verbindung zwischen dem Steckverbinder und der Leiterplatte;
- Bereitstellen eines elektrischen Prüfsignals mit ersten Eigenschaften am Prüfkontakt;
- Messen eines elektrischen Ausgangssignals des zweiten Teilschaltkreises der Leiterplatte mithilfe eines Messinstruments;
- Vergleichen des Prüfsignals und des Ausgangssignals mithilfe einer Datenverarbeitungseinheit und Schlussfolgern auf eine korrekte oder inkorrekte Verbindung in Abhängigkeit vom Ergebnis des Vergleichs.

15. Verfahren zur Diagnose der Verbindungen zwischen den Steckverbindern und den jeweiligen Leiterplatten eines Lichtmoduls nach Anspruch 13, umfassend die folgenden Schritte:
- Bereitstellen einer Verbindung zwischen den Steckverbindern und den Leiterplatten;
- Bereitstellen eines elektrischen Prüfsignals mit ersten Eigenschaften am Prüfkontakt jedes Verbindungsensembles;
- Messen eines elektrischen Ausgangssignals des zweiten Teilschaltkreises jeder Leiterplatte mithilfe eines Messinstruments;
- Vergleichen des Prüfsignals und des Ausgangssignals mithilfe einer Datenverarbeitungseinheit und Schlussfolgern auf eine korrekte oder inkorrekte Verbindung der Leiterplatten in Abhängigkeit vom Ergebnis des Vergleichs.

## Claims

1. An electrical connection assembly (100, 200, 300, 400, 500, 600, 700, 800, 900, 1000, 1100) comprising a connector (110, 410, 510, 610, 710, 810, 910, 1010, 1110) and a printed circuit (120, 220, 320, 420, 520, 620, 720, 820, 920, 1020, 1120) that comprises a socket (130, 1030, 1130) corresponding to the connector and a first electronic subcircuit (122, 222, 322, 422, 522, 622, 722, 822, 922, 1022, 1122) that contributes to performing a luminous function for a motor vehicle, the connector comprising a plurality of electrical contacts (111, 411, 511, 611, 711, 811, 911, 1011, 1111), the connector, by means of the electrical contacts, enabling a power supply source to be connected to the first sub-circuit of the printed circuit board,
**characterized in that** the connector further comprises a verification contact (112, 412, 512, 612, 712, 812, 912, 1012, 1112) intended to transmit an electrical signal for verifying the electrical connection between the connector and the printed circuit, wherein the printed circuit comprises a second subcircuit (124, 224, 324, 424, 524, 624, 724, 824, 924, 1024, 1124) having a contact terminal (125, 225, 325, 425, 525, 625, 725, 825, 925, 1025, 1125) intended to be connected to said verification contact in the event of the connector being held in the socket, such that the electrical signal undergoes a change upon passing through the second sub-circuit.

2. The connection assembly as claimed in claim 1, **characterized in that** the connector and the socket comprise a mutual mechanical engagement structure (113, 132), which makes it possible to produce a first mechanical engagement corresponding to a first, lesser degree, and a second mechanical engagement corresponding to a second, greater degree of pushing of the connector into the socket, and **in that** the arrangement of the verification contact (112) and of the contact terminal of the second subcircuit (125) is such that they are in electrical contact if the second mechanical engagement of the structure is engaged.

3. The connection assembly as claimed in either of claims 1 and 2, **characterized in that** the socket comprises a plurality of contacts extending over a first length, and **in that** the contact terminal (425, 525, 625, 725, 825, 925, 1025, 1125) extends over a second, shorter length.

4. The connection assembly as claimed in one of claims 1 to 3, **characterized in that** the first subcircuit comprises at least one electroluminescent semiconductor element-based light source.

5. The connection assembly as claimed in one of claims 1 to 4, **characterized in that** the second subcircuit (224, 324, 424, 524) is arranged so as to be connected to ground potential when the connector is plugged into the socket.

6. The connection assembly as claimed in claim 5, **characterized in that** the second subcircuit is arranged so as to connect the contact terminal to ground potential through at least one branch that comprises a capacitor, an inductor, a resistor, or a combination of the above.

7. The connection assembly as claimed in one of claims 1 to 4, **characterized in that** the connector comprises a first contact (611, 711, 811, 911) intended to supply a first non-zero electrical potential to the first subcircuit, and a second contact (611', 711', 811', 911') intended to supply a second non-zero electrical potential to the first subcircuit, and **in that** the arrangement is such that the contact terminal (625, 725, 825, 925) is connected to the first electrical potential when the connector is plugged into the socket.

8. The connection assembly as claimed in claim 7, **characterized in that** the second subcircuit is connected to the second electrical potential when the connector is plugged into the socket.

9. The connection assembly as claimed in claim 8, **characterized in that** the second subcircuit comprises at least one branch comprising a capacitor, an inductor, a resistor or a combination of the above.

10. The connection assembly as claimed in either of claims 8 and 9, **characterized in that** the second subcircuit comprises a fuse.

11. The connection assembly as claimed in one of claims 1 to 4, **characterized in that** the second subcircuit (1024) is arranged so as to connect the contact terminal to ground potential through a branch comprising a resistive component, and optionally, that additionally comprises a capacitor, an inductor, a resistor, or a combination of the above.

12. The connection assembly as claimed in one of claims 1 to 4, **characterized in that** the second subcircuit comprises an electronic component (F) intended to self-destruct upon the flow of an electric current having at least a predetermined threshold strength.

13. A luminous module for a motor vehicle, comprising a plurality of connection assemblies as claimed in claim 11.

14. A method for diagnosing the connection between a connector and a printed circuit forming a connection assembly as claimed in any one of claims 1 to 12, the method comprising the following steps:
- making available a connection between the connector and the printed circuit;
- providing an electrical verification signal, having first characteristics, at the verification contact;
- using a measuring instrument to measure an output electrical signal from the second subcircuit of the printed circuit;
- using a data processing unit to compare the verification signal and the output signal, and to conclude as to a correct or incorrect connection depending on the result of the comparison.

15. A method for diagnosing connections between the respective connectors and printed circuits of a luminous module as claimed claim 13, comprising the following steps:
- making available a connection between the connectors and the printed circuits;
- providing an electrical verification signal, having first characteristics, at the verification contact of each connection assembly;
- using a measuring instrument to measure an output electrical signal from the second subcircuit of each printed circuit;
- using a data processing unit to compare the verification signal and the output signal, and to conclude as to a correct or incorrect connection of the printed circuits depending on the result of the comparison.
